(19) Europäisches Patentamt
European Patent Office
Office européen des brevets

(11) **EP 1 295 389 B1**

(12) **FASCICULE DE BREVET EUROPEEN**

(45) Date de publication et mention
de la délivrance du brevet:
**31.10.2007 Bulletin 2007/44**

(21) Numéro de dépôt: **01949584.5**

(22) Date de dépôt: **29.06.2001**

(51) Int Cl.:
**H03H 9/46** *(2006.01)*    **H03H 9/15** *(2006.01)*

(86) Numéro de dépôt international:
**PCT/FR2001/002087**

(87) Numéro de publication internationale:
**WO 2002/001717 (03.01.2002 Gazette 2002/01)**

(54) **FILTRE NANO-ELECTROMECANIQUE**

NANO-ELEKTROMECHANISCHES FILTER

NANO-ELECTROMECHANICAL FILTER

(84) Etats contractants désignés:
**AT BE CH CY DE DK ES FI FR GB GR IE IT LI LU MC NL PT SE TR**

(30) Priorité: **30.06.2000 FR 0008490**

(43) Date de publication de la demande:
**26.03.2003 Bulletin 2003/13**

(73) Titulaire: **CENTRE NATIONAL DE LA RECHERCHE SCIENTIFIQUE (CNRS)**
**75794 Paris Cedex 16 (FR)**

(72) Inventeurs:
• **BUCHAILLOT, Lionel**
**F-59800 Lille (FR)**

• **COLLARD, Dominique, Jules, Vi**
**F-59130 Lambersart (FR)**

(74) Mandataire: **Bredema et al**
**38, avenue de l'Opéra**
**75002 Paris (FR)**

(56) Documents cités:
• **WANG K ET AL: "Q-ENHANCEMENT OF MICROELECTROMECHANICAL FILTERS VIA LOW-VELOCITY SPRING COUPLING" IEEE ULTRASONICS SYMPOSIUM PROCEEDINGS, US,NEW YORK, NY: IEEE, 5 octobre 1997 (1997-10-05), pages 323-327, XP000848487 ISBN: 0-7803-4154-6**

EP 1 295 389 B1

## Description

La présente invention concerne un filtre électrique et, plus précisément, un filtre électromécanique passe-bande.

Elle s'applique notamment au domaine du filtrage pour les télécommunications sans fil telles que la téléphonie mobile et pour les agendas électroniques.

Elle trouve aussi des applications dans le domaine du multimédia où l'on utilise des moyens de télécommunication portables.

Elle trouve également des applications dans les dispositifs qui nécessitent la sélection de signaux de haute fréquence, comme par exemple les cartes à puce.

## ETAT DE LA TECHNIQUE ANTERIEURE

Actuellement, les services de télécommunication ont à faire face à un nombre sans cesse croissant d'utilisateurs. Compte tenu des limitations d'attribution des bandes de fréquence, cela implique, de la part des prestataires de service, de plus grandes exigences en ce qui concerne l'utilisation de leur largeur de bande.

Les spécifications liées aux bandes passantes se répercutent sur les contraintes des dispositifs de filtrage, lesquels doivent être sélectifs. On est donc conduit à améliorer le coefficient de qualité des filtres tout en respectant les contraintes d'encombrement, contraintes qui sont primordiales pour des appareils de télécommunications mobiles tels que les téléphones portables et les organiseurs par exemple.

Actuellement, dans le domaine des télécommunications mobiles, la fonction de filtrage est réalisée par des filtres à onde de surface. Ils sont en quartz et ont de bonnes caractéristiques sauf en ce qui concerne l'encombrement, la masse et les pertes par insertion dans un circuit électronique.

Il est possible de réduire l'encombrement, la masse et les pertes par insertion en utilisant des filtres électromécaniques ou, plus exactement, microélectromécaniques compte tenu de leur taille, qui sont réalisés avec des techniques identiques à celles qui servent à fabriquer les circuits microélectroniques, en supprimant ainsi les inconvénients inhérents à l'hybridation.

Des tels filtres sont connus p.ex. de l'article "Q-Enhancement of Microelectromechanical Filters via Low-Velocity Spring Coupling de K. Wang et al., IEEE Ultrasonics Symposium 05.10.1997, pp. 323-327.

En revanche, les conceptions actuelles de ces filtres microélectromécaniques ne permettent pas d'atteindre des fréquences supérieures à 400 MHz et, à plus forte raison, les bandes de fréquence utilisées par les télécommunications, bandes qui se situent au voisinage de 1 GHz ou au-delà.

## EXPOSÉ DE L'INVENTION

La présente invention a pour but de remédier à cet inconvénient en proposant un filtre électromécanique qui utilise une structure résonante de conception appropriée et, plus précisément, une nanostructure résonante.

De plus, le coût de fabrication d'un filtre conforme à l'invention est susceptible d'être faible grâce à l'utilisation de techniques d'usinage collectif.

Par rapport aux filtres à onde de surface mentionnés plus haut, un filtre conforme à l'invention présente l'avantage d'être plus facilement insérable dans un circuit électronique car la fabrication de ce filtre utilise la même technique que la fabrication d'un tel circuit et ne nécessite pas de phase d'hybridation.

De façon précise, la présente invention a pour objet un filtre électromécanique caractérisé en ce qu'il comprend :

- un substrat,

- au moins une micropointe (« microtip ») qui est formée sur le substrat et dont le sommet se prolonge par une nanostructure en forme de poutre qui s'étend suivant l'axe de la micropointe, cette micropointe et la nanostructure étant, au moins superficiellement, électriquement conductrices, la nanostructure formant un résonateur électromécanique,

- une couche électriquement isolante qui est formée sur le substrat et comprend une cavité dans laquelle se trouve la micropointe et, sensiblement au niveau du sommet de cette micropointe, un perçage qui prolonge la cavité et dont le bord entoure ce sommet, et

- au moins une électrode d'entrée et au moins une électrode de sortie qui sont formées sur la couche isolante et aboutissent sensiblement au bord du perçage, de part et d'autre de l'axe de la micropointe, l'électrode d'entrée étant prévue pour recevoir un signal électrique à filtrer et l'électrode de sortie étant prévue pour fournir un signal électrique filtré, un couplage étant créé entre ces électrodes et la nanostructure, ce couplage permettant la mise en résonance du résonateur électromécanique.

De préférence, la micropointe et la nanostructure sont métallisées (de façon à les rendre électriquement conductrices).

Selon un mode de réalisation particulier du filtre objet de l'invention, la micropointe est associée à deux électrodes de sortie dont l'une est électriquement reliée à l'électrode d'entrée.

Selon un mode de réalisation particulier de l'invention, la micropointe et la nanostructure sont revêtues d'une couche d'un métal magnétique, apte à produire un champ magnétique sensiblement parallèle à l'axe de la micropointe.

Selon un premier mode de réalisation particulier du filtre objet de l'invention, ce filtre comprend plusieurs micropointes respectivement munies d'électrodes d'entrée, d'électrodes de sortie et de nanostructures qui forment des résonateurs électromécaniques ayant une même fréquence de résonance, les électrodes d'entrée étant électriquement reliées les unes aux autres et les électrodes de sortie étant aussi électriquement reliées les unes aux autres.

Selon un deuxième mode de réalisation particulier, ce filtre comprend plusieurs micropointes respectivement munies d'électrodes d'entrée, d'électrodes de sortie et de nanostructures qui forment des résonateurs électromécaniques, ces micropointes étant réparties en une pluralité de groupes, les résonateurs électromécaniques associés aux micropointes d'un même groupe ayant la même fréquence de résonance, les électrodes d'entrée étant électriquement reliées les unes aux autres et les électrodes de sortie associées aux micropointes d'un même groupe étant électriquement reliées les unes aux autres.

Selon un mode de réalisation particulier de l'invention, chaque résonateur électromécanique est dans un espace où l'on a fait le vide (« vacuum »).

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

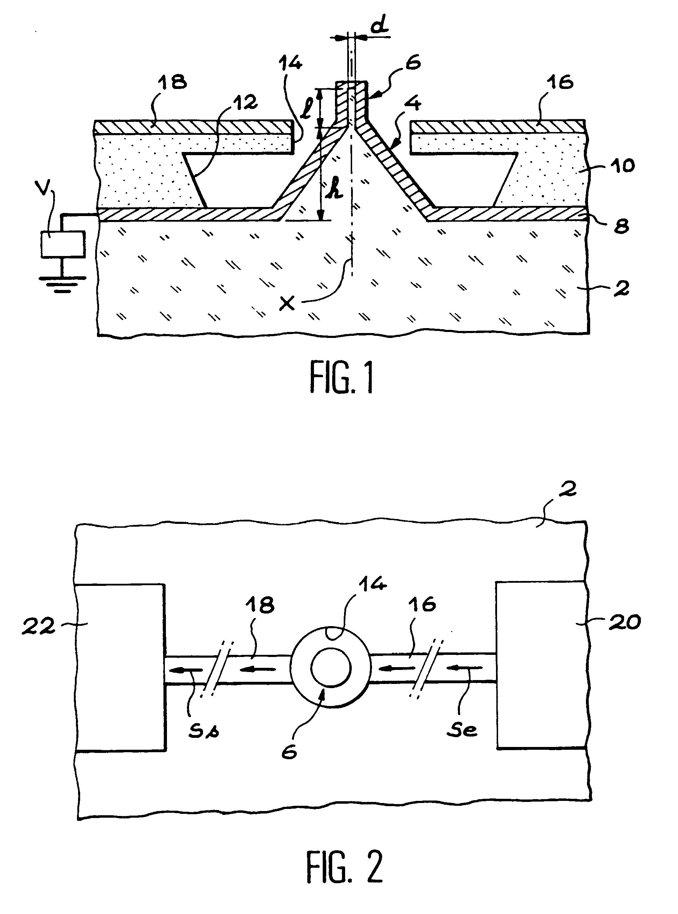

■ la figure 1 est une vue en coupe schématique d'un mode de réalisation particulier du filtre objet de l'invention, ne comprenant qu'une micropointe,

■ la figure 2 est une vue de dessus schématique du filtre de la figure 1 dans lequel on utilise une électrode d'entrée et une électrode de sortie,

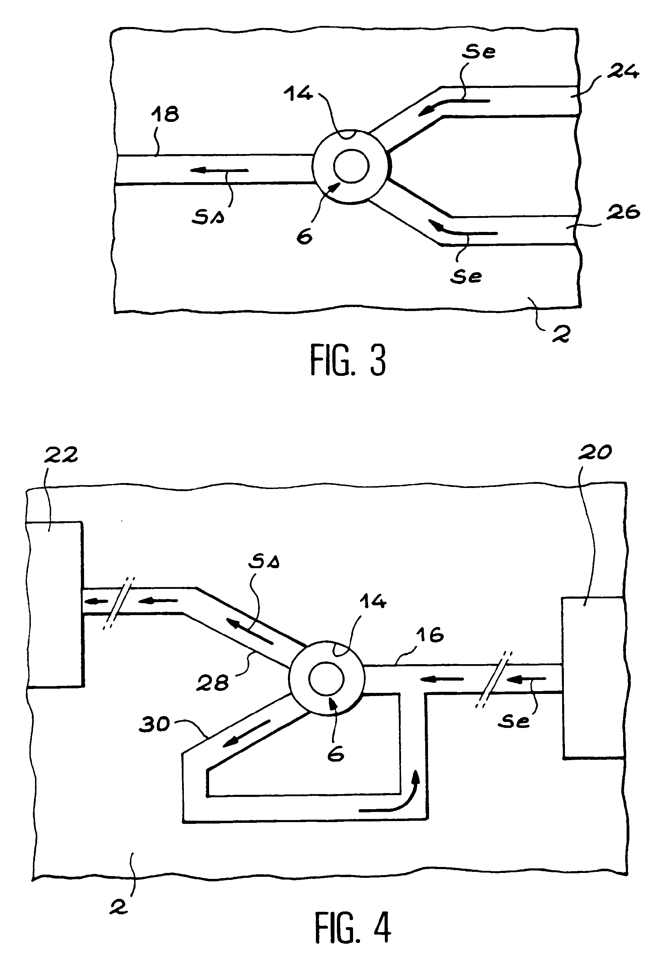

■ la figure 3 est une vue de dessus schématique d'un autre filtre conforme à l'invention dans lequel on utilise deux électrodes d'entrée et une électrode de sortie,

■ la figure 4 est une vue de dessus schématique d'un autre filtre conforme à l'invention dans lequel on utilise une électrode d'entrée et deux électrodes de sortie,

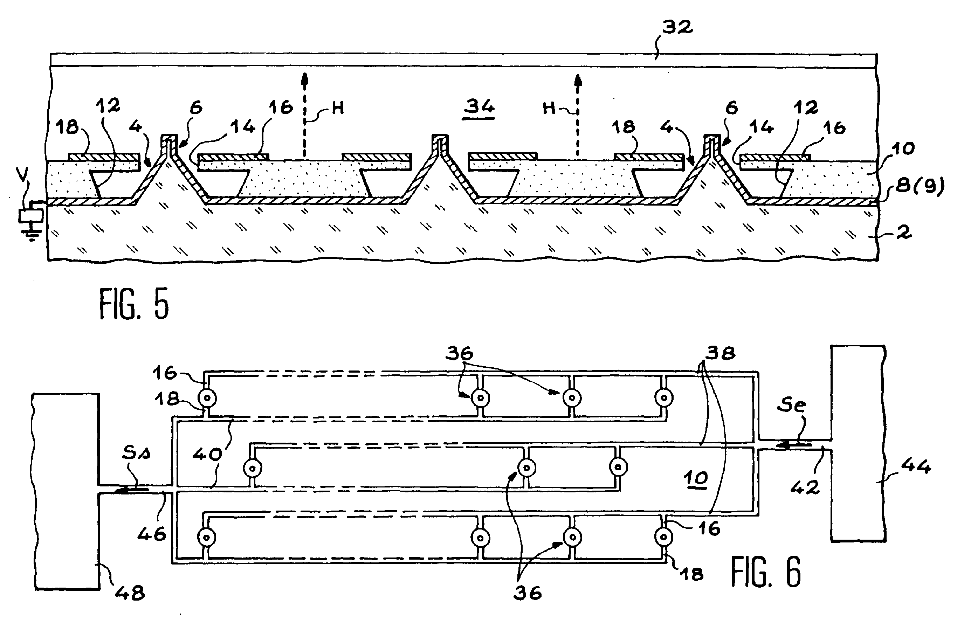

■ la figure 5 est une vue en coupe schématique d'un autre filtre conforme à l'invention comprenant plusieurs micropointes,

■ la figure 6 est une vue de dessus schématique d'un filtre conforme à l'invention, ce filtre comprenant un groupe de filtres élémentaires (filtres comprenant une seule micropointe) dont les résonateurs électromécaniques ont tous la même fréquence de résonance,

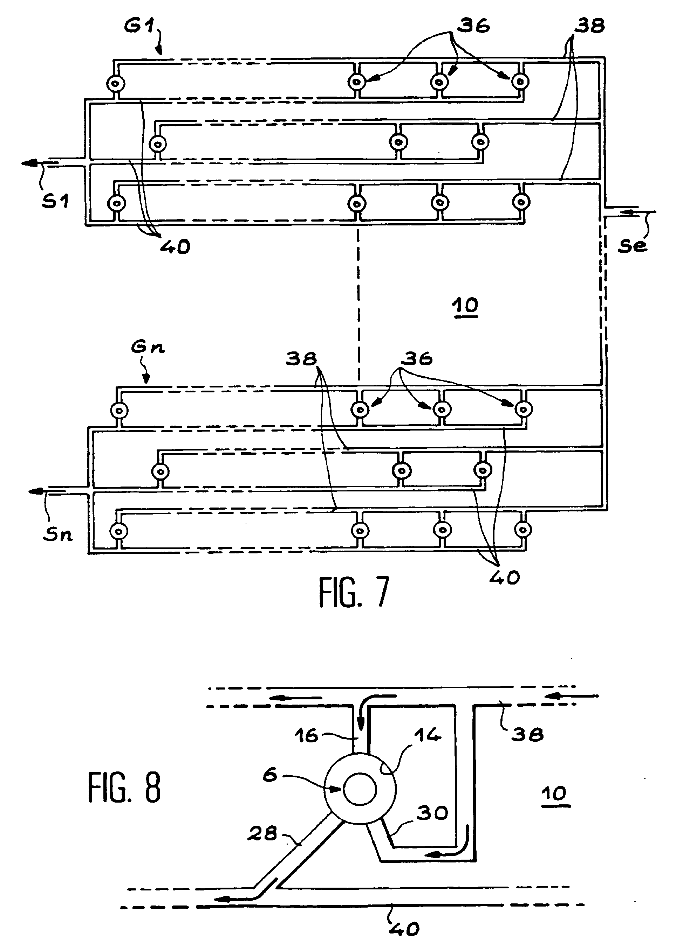

■ la figure 7 est une vue de dessus schématique d'un autre filtre conforme à l'invention, ce filtre comprenant plusieurs groupes de filtres élémentaires, les résonateurs électromécaniques d'un même groupe ayant la même fréquence de résonance et

■ la figure 8 est une vue de dessus schématique et partielle d'une variante de réalisation des filtres des figures 6 et 7.

## EXPOSÉ DÉTAILLÉ DE MODES DE RÉALISATION PARTICULIERS

Un filtre élémentaire conforme à l'invention est un filtre passe-bande comprenant un résonateur électromécanique (un nanorésonateur compte tenu de sa taille dont des exemples sont donnés plus loin). Il est fondé sur la technique des microsystèmes.

Ce filtre élémentaire permet de filtrer un signal électrique dont la fréquence est supérieure à 400 MHz : la bande des fréquences de ce filtre élémentaire passe-bande est centrée sur une fréquence f supérieure à 400 MHz et susceptible d'atteindre 1 GHz voire plus ; en outre, cette bande est étroite : sa largeur est susceptible de ne pas dépasser 100 kHz.

La figure 1 est une vue en coupe schématique d'un filtre conforme à l'invention. Il s'agit d'un filtre élémentaire comprenant un seul nanorésonateur électromécanique.

Plus précisément, le filtre élémentaire de la figure 1 est formé sur un substrat 2 et comprend une micropointe 4 sensiblement conique, formée sur ce substrat 2. L'axe de cette micropointe est noté X. Le sommet de cette micropointe se prolonge par une nanostructure 6 en forme de poutre, appelée « nanopoutre » dans ce qui suit, qui s'étend suivant l'axe X.

Sur la figure 1, les références h, l et d désignent respectivement la hauteur de la micropointe 4, la longueur de la nanopoutre 6 et le diamètre de cette dernière.

Le filtre élémentaire de la figure 1 comprend aussi une couche métallique 8 mise à un potentiel V quelconque, qui s'étend sur le substrat 2 et recouvre la micropointe 4 ainsi que la nanopoutre 6 dont cette micropointe est munie. De plus, une couche électriquement isolante 10 est formée sur cette couche métallique 8.

Une cavité 12 est formée dans cette couche isolante 10 et contient la micropointe 4 comme on le voit sur la figure 1. De plus, cette couche isolante 10 comporte un perçage 14 qui prolonge la cavité 12 et dont l'axe est l'axe X.

Ce perçage 14 entoure le sommet de la micropointe. On voit que la nanopoutre 6 émerge de la couche isolante 10.

On précise que l'on sait fabriquer une micropointe munie d'une telle nanopoutre en vue d'une utilisation dans le domaine de la microscopie à champ proche.

En se reportant à la figure 2, qui est une vue de dessus schématique de la figure 1, on voit que le filtre élémentaire comprend aussi une électrode d'entrée 16 et une électrode de sortie 18 qui sont sensiblement alignées et dont deux extrémités respectives sont diamétralement opposées sur le bord du perçage 14.

On voit sur la figure 2 que le filtre élémentaire fait partie d'un circuit électronique en vue de filtrer un signal électrique engendré ou reçu dans ce circuit.

Plus précisément, ce filtre élémentaire relie une première partie 20 du circuit à une deuxième partie 22 de ce dernier. Ces deux parties de ce circuit sont formées sur le même substrat 2 que le filtre élémentaire par des techniques de la microélectronique qui sont également utilisées pour la fabrication de ce filtre comme on les verra plus loin.

A titre d'exemple, la première partie 20 du circuit électronique est une antenne d'un téléphone portable et fournit un signal électrique Se, ou signal d'entrée, que l'on veut filtrer. La deuxième partie 22 du circuit comprend des moyens d'amplification et de traitement du signal filtré Ss ou signal de sortie.

Le signal d'entrée Se excite le nanorésonateur constitué par la nanopoutre métallisée qui filtre ce signal Se pour ne laisser passer que les composantes du signal Se dont les fréquences appartiennent à la bande passante du filtre élémentaire.

Cette bande passante dépend des caractéristiques géométriques et des matériaux constitutifs de la micropointe et de la nanopoutre métallisées.

A titre purement indicatif et nullement limitatif, le substrat 2 et la micropointe 4 ainsi que la nanopoutre associée 6 sont en silicium ; la couche 8 de métallisation de la micropointe et de la nanopoutre est en or ou en tungstène ; l'électrode d'entrée 16 et l'électrode de sortie 18 sont également en or ou en tungstène ; la couche isolante 10 est en silice ou en nitrure de silicium ou en un polymère électriquement isolant ; le rapport h/l vaut approximativement 10 et le diamètre d vaut approximativement l/10 avec h de l'ordre de 1 micromètre à 4 micromètres.

Le mode de réalisation du filtre élémentaire qui est schématiquement représenté en vue de dessus sur la figure 3 se distingue de celui de la figure 2 par le fait qu'il comprend deux électrodes d'entrée 24 et 26 au lieu d'une seule.

Comme on le voit, ces deux électrodes d'entrée ont des extrémités sensiblement sur le bord du perçage 14, d'un côté de celui-ci, tandis que l'électrode de sortie 18 a une extrémité au bord de ce perçage 14, sensiblement à l'opposé des extrémités respectives des électrodes d'entrée 24 et 26.

Ces derniers reçoivent toutes deux le signal Se que l'on veut filtrer et constituent ainsi une source d'excitation plus importante pour le nanorésonateur que dans le cas de la figure 2 où une seule électrode d'entrée est prévue.

Le filtre élémentaire conforme à l'invention, dont la figure 4 est une vue de dessus schématique, diffère de celui de la figure 2 par le fait qu'il comprend deux électrodes de sortie 28 et 30 au lieu d'une seule.

Les extrémités respectives de ces électrodes de sortie se trouvent encore au bord du perçage 14, sensiblement à l'opposé de l'extrémité de l'électrode d'entrée 16 qui se trouve également sur le bord, comme on le voit sur la figure 4.

L'une 28 de ces électrodes de sortie recueille une partie du signal filtré Ss, pour le faire parvenir au circuit d'amplification et de traitement 22 comme précédemment, tandis l'autre électrode de sortie 30 recueille une partie de ce signal filtré Ss en vue d'un asservissement en boucle fermée du filtre : comme on le voit, cette autre électrode de sortie 30 forme sensiblement une boucle qui est reliée à l'électrode d'entrée 16.

Cet asservissement en boucle fermée permet d'améliorer la commande du filtre.

Dans un mode de réalisation particulier non représenté on utilise encore deux électrodes de sortie mais il n'y a pas d'asservissement en boucle fermée : ces deux électrodes sont toutes deux reliées à un circuit d'amplification et de traitement du signal de sortie Ss.

Pour augmenter le courant disponible à la sortie d'un filtre passe-bande conforme à l'invention, il est préférable que ce filtre comprenne plusieurs filtres élémentaires (comprenant chacun un seul nanorésonateur).

Ceci est illustré par la figure 5 qui est une vue en coupe schématique d'un filtre conforme à l'invention.

Ce filtre comprend, sur le substrat 2, plusieurs micropointes 4 respectivement surmontées de nanopoutres 6. Ces micropointes et les nanopoutres correspondantes sont encore métallisées par la couche conductrice 8 qui s'étend sur le substrat 2 et qui est mise à un potentiel V quelconque.

En variante, les micropointes ne sont pas toutes au même potentiel : elles sont polarisées individuellement ou réparties en groupes, les micropointes d'un même groupe étant au même potentiel.

En revenant à la figure 5, chaque micropointe 4 est encore logée dans une cavité formée dans une couche électriquement isolante 10 qui s'étend sur le substrat 2 au-dessus de la couche 8 et l'on voit les perçages 14 de la couche isolante 10, dont émergent les nanopoutres 6.

Sur la figure 5, on voit trois micropointes 4 mais, en pratique, il est possible de former plusieurs centaines de micropointes et donc plusieurs centaines de filtres élémentaires sur le substrat 2.

On voit sur la figure 5 une électrode d'entrée 16 et une électrode de sortie 18 de part et d'autre de chaque micropointe. Ces électrodes se prolongent perpendiculairement au plan de la figure 5.

Pour améliorer le fonctionnement d'un filtre conforme à l'invention, en particulier le filtre de la figure 5, il est possible de prévoir un couvercle étanche 32 qui emprisonne ce filtre. Le bord (non représenté) de ce couvercle est hermétiquement scellé sur le bord du substrat 2 sur lequel on a formé ce filtre et les circuits électroniques associés. On fait en outre le vide dans l'espace 34 compris entre ce couvercle et le substrat. On explique dans ce qui suit la fabrication d'un filtre conforme à l'invention.

On commence par former la micropointe ou, en pratique, les micropointes sur le substrat. On forme ensuite les nanopoutres. Pour la fabrication des micropointes on se reportera par exemple au document suivant :

Rakhshanderoo, M.R. et Pang, S. W., J. Vac. Sci. Technol. B 15(6) 2777 (1997).

Ces micropointes, entourées de la couche électriquement isolante, sont du genre de celles qui sont utilisées dans les cathodes à émission de champ. Cependant, dans la présente invention, l'obtention des nanorésonateurs nécessite l'amincissement des extrémités respectives des micropointes pour former les nanopoutres.

Après avoir formé les micropointes munies des nanopoutres correspondantes, on métallise ces micropointes et les nanopoutres puis on forme sur le substrat 2 ainsi métallisé la couche électriquement isolante 10 ou couche sacrificielle.

On grave cette dernière de façon à obtenir les cavités et les perçages 14 au niveau des différentes micropointes.

Par exemple, dans le cas où la couche sacrificielle 12 est en silice, on utilise une gravure ionique réactive pour former ces cavités et perçages.

On forme ensuite les électrodes 16 et 18 sur la couche 12 ainsi gravée.

La figure 6 est une vue de dessus schématique d'un autre filtre conforme à l'invention, comprenant un grand nombre de filtres élémentaires identiques 36 et donc un grand nombre de nanorésonateurs électromécaniques élémentaires.

Dans l'exemple de la figure 6, tous ces nanorésonateurs ont donc la même fréquence de résonance. De plus, on voit sur la figure 6 diverses pistes électriquement conductrices 38 et 40 qui sont formées à la surface de la couche isolante du filtre pour relier les différents filtres élémentaires 36 constituant ce filtre.

On voit que le filtre de la figure 6 comprend plusieurs rangées de filtres élémentaires et, dans chaque rangée, toutes les électrodes d'entrée 16 sont reliées les unes aux autres par l'intermédiaire d'une piste conductrice 38 ou piste conductrice d'entrée.

De même, dans chaque rangée, toutes les électrodes de sortie 18 sont reliées les unes aux autres par l'intermédiaire d'une autre piste conductrice 40 ou piste conductrice de sortie.

Les pistes conductrices d'entrée 38 sont reliées les unes aux autres ainsi qu'à une piste conductrice 42 qui est elle-même reliée à une partie 44 d'un circuit électronique, destinée à fournir le signal électrique Se que l'on veut filtrer.

De même, les pistes conductrices de sortie 40 sont reliées les unes aux autres ainsi qu'à une piste conductrice 46 qui est elle-même reliée à une autre partie 48 du circuit électronique, destinée à amplifier et traiter le signal filtré Ss.

La figure 7 est une vue de dessus schématique d'un autre filtre conforme à l'invention comprenant n groupes G1 à Gn de filtres élémentaires, avec n ≥ 2.

Dans chaque groupe, les nanorésonateurs ont tous la même fréquence de résonance : les nanorésonateurs du premier groupe G1 ont ainsi une même fréquence de résonance F1 etc. et le nième groupe Gn a une fréquence de résonance Fn.

Ces fréquences de résonance F1 à Fn sont différentes les unes des autres.

Dans l'exemple de la figure 7, chaque groupe a la configuration de l'ensemble des filtres élémentaires de la figure 6.

Dans cet exemple de la figure 7, on a donc, dans chaque groupe, le même arrangement de pistes conductrices que dans le cas de la figure 6.

On précise que les pistes conductrices d'entrée 38 sont toutes reliées les unes aux autres de façon qu'elles reçoivent toutes le signal électrique d'entrée Se que l'on veut filtrer.

Les pistes conductrices de sortie 40 d'un même groupe sont reliées les unes aux autres pour fournir un signal de sortie : les groupes G1 à Gn fournissent respectivement des signaux de sortie S1 à Sn.

Chaque groupe de filtres élémentaires constitue un filtre passe-bande qui ne laisse passer que des signaux dont les fréquences sont comprises dans une bande de fréquence déterminée, centrée sur la fréquence F1 pour le premier groupe G1 et sur la fréquence Fn pour le nième groupe Gn.

On peut ensuite traiter chaque signal de sortie par un circuit électronique qui peut être formé sur le substrat sur lequel est formé le filtre de la figure 7. Le circuit électronique fournissant le signal à filtrer peut également être formé sur ce substrat.

Pour les filtres des figures 6 et 7, on peut prévoir un asservissement en boucle fermée. Comme le montre la figure 8, il suffit, pour ce faire, que chaque filtre élémentaire 36 possède deux électrodes de sortie 28 et 30 au lieu d'une seule, l'électrode de sortie 28 étant reliée à la piste de sortie 40 tandis que l'autre électrode de sortie 30 forme une boucle pour être reliée à la piste d'entrée 38 (et donc à l'électrode d'entrée 16).

Dans un mode de réalisation particulier de l'invention, la métallisation des micropointes et des nanopoutres associées est faite au moyen d'une couche 9 d'un métal magnétique (figure 5), par exemple l'alliage fer-nickel. Dans ce cas, lors de la fabrication du filtre, on place le substrat portant ce filtre dans un champ magnétique intense pour aimanter la couche de métallisation 9.

Dans ce mode de réalisation particulier, on n'a pas besoin de polariser cette couche de métallisation 9.

On précise que le champ magnétique H (figure 5), engendré par la couche de métallisation 9 ainsi aimantée, est sensiblement perpendiculaire au plan du substrat 2, comme on le voit sur la figure 5.

On se reportera au document suivant :

Géradin, M., Rixen, D., Théorie des vibrations, éditions Masson (1993).

D'après ce document, il est possible de calculer analytiquement la fréquence de résonance F d'une nanostructure en forme de poutre, excitée dans le vide, c'est-à-dire en négligeant l'amortissement dû à l'air, ce qui correspond à un nanorésonateur encapsulé sous vide.

On peut par exemple calculer cette fréquence de résonance dans le cas (A) où la nanostructure en forme de poutre a une longueur 1 de 100 nanomètres et un diamètre $\underline{d}$ de 30 nanomètres ou dans le cas (B) où cette longueur vaut 100 nanomètres et le diamètre correspondant 30 nanomètres.

L'équation permettant de calculer la fréquence de résonance est la suivante :

$$\left(2\pi F\right)^2 = \omega^2 = \mu^4 \frac{EI}{Ml^4} \text{ avec } I = \frac{\pi d^4}{64}$$

Dans cette équation, E représente le module d'Young exprimé en Pa, M représente la masse par unité de longueur, exprimée en kg/m et I est le moment quadratique de la nanopointe exprimé en $m^4$.

Dans les deux cas ci-dessus, pour une nanopoutre en silicium, E vaut $1,9 \times 10^{11}$ Pa, M vaut 1, $626 \times 10^{-12}$ kg/m et I vaut $3,976 \times 10^{-32}$ $m^4$.

Le coefficient $\mu$ dépend du mode de vibration. Dans le cas du premier mode de vibration, qui est un mode de flexion, $\mu$ vaut 1,875.

Dans le cas (A), la fréquence de résonance vaut $1,206 \times 10^{13}$ Hz et, dans le cas (B), cette fréquence vaut $4,238 \times 10^8$ Hz. On constate que dans le cas le plus défavorable et pour le premier mode de vibration la fréquence de résonance est supérieure à 400 MHz et donc supérieure à celles que procure l'art antérieur.

Dans les exemples de l'invention que l'on a donnés, on a rendu les micropointes et les nanopoutres électriquement conductrices en formant, sur le substrat, les micropointes et les nanopoutres, une couche de métallisation.

On ne sortirait pas du cadre de l'invention en formant des micropointes conductrices, par exemple en dopant fortement le silicium, sur un substrat rendu isolant par exemple par une couche d'oxyde isolant (chose que l'on sait faire notamment pour la fabrication des écrans à micropointes) et en formant ensuite les nanopoutres au sommet des micropointes par une technique de gravure ionique réactive. Il n'est alors plus nécessaire de métalliser les micropointes et les nanopoutres.

**Revendications**

1. Filtre électromécanique **caractérisé en ce qu'**il comprend :

   - un substrat (2),
   - au moins une micropointe (4) qui est formée sur le substrat et dont le sommet se prolonge par une nanostructure

(6) en forme de poutre qui s'étend suivant l'axe (X) de la micropointe, cette micropointe et la nanostructure étant, au moins superficiellement, électriquement conductrices, la nanostructure formant un résonateur électromécanique,

- une couche (10) électriquement isolante qui est formée sur le substrat et comprend une cavité (12) dans laquelle se trouve la micropointe et, sensiblement au niveau du sommet de cette micropointe, un perçage (14) qui prolonge la cavité et dont le bord entoure ce sommet, et

- au moins une électrode d'entrée (16 ; 24-26) et au moins une électrode de sortie (18 ; 28-30) qui sont formées sur la couche isolante et aboutissent sensiblement au bord du perçage, de part et d'autre de l'axe de la micropointe, l'électrode d'entrée étant prévue pour recevoir un signal électrique à filtrer et l'électrode de sortie étant prévue pour fournir un signal électrique filtré, un couplage étant créé entre ces électrodes et la nanostructure, ce couplage permettant la mise en résonance du résonateur électromécanique.

2. Filtre selon la revendication 1, dans lequel la micropointe (4) et la nanostructure (6) sont métallisées.

3. Filtre selon l'une quelconque des revendications 1 et 2, dans lequel la micropointe (4) est associée à deux électrodes de sortie (28, 30) dont l'une est électriquement reliée à l'électrode d'entrée (16).

4. Filtre selon l'une quelconque des revendications 1 à 3, dans lequel la micropointe (4) et la nanostructure sont revêtues d'une couche (9) d'un métal magnétique, apte à produire un champ magnétique sensiblement parallèle à l'axe (X) de la micropointe.

5. Filtre selon l'une quelconque des revendications 1 à 4, comprenant plusieurs micropointes (4) respectivement munies d'électrodes d'entrée (16), d'électrodes de sortie (18) et de nanostructures (6) qui forment des résonateurs électromécaniques ayant une même fréquence de résonance, les électrodes d'entrée étant électriquement reliées les unes aux autres et les électrodes de sortie étant aussi électriquement reliées les unes aux autres.

6. Filtre selon l'une quelconque des revendications 1 à 4, comprenant plusieurs micropointes (4) respectivement munies d'électrodes d'entrée (16), d'électrodes de sortie (18) et de nanostructures (6) qui forment des résonateurs électromécaniques, ces micropointes étant réparties en une pluralité de groupes (G1 à Gn), les résonateurs électromécaniques associés aux micropointes d'un même groupe ayant la même fréquence de résonance, les électrodes d'entrée (16) étant électriquement reliées les unes aux autres et les électrodes de sortie (18) associées aux micropointes d'un même groupe étant électriquement reliées les unes aux autres.

7. Filtre selon l'une quelconque des revendications 1 à 6, dans lequel chaque résonateur électromécanique est dans un espace (34) où l'on a fait le vide.

**Claims**

1. An electro-mechanical filter **characterized in that** it includes:

- a substrate (2),
- at least one microtip (4) which is formed on the substrate and the top of which is extended by a nanostructure (6) having the shape of a beam which extends along (X) axis of the microtip, such microtip and the nanostructure being, at least superficially, electrically conductive, the nanostructure forming an electro-mechanical resonator,
- an electrically isolating layer (10) which is formed on the substrate and includes a cavity (12) wherein the microtip is located and, substantially at the top of such microtip, a boring (14) which extends the cavity and the edge of which surrounds such top, and
- at least one input electrode (16;24-2.6)) and at least one output electrode (18;28,30) which are formed on the isolating layer and end up substantially at the edge of the boring, on either side of the microtip axis, the input electrode being provided for receiving an electric signal to be filtered and the output electrode being provided for supplying a filtered electric signal, a coupling being created between such electrodes and the nanostructure, such coupling making it possible for the electro-mechanical resonator to resonate.

2. A filter according to claim 1, wherein the microtip (4) and the nanostructure (6) are metallized.

3. A filter according to any one of claims 1 and 2, wherein the microtip (4) is associated with two output electrodes (28,30) one of which is electrically connected to the input electrode (16).

4. A filter according to any one of claims 1 to 3, wherein the microtip (4) and the nanostructure are coated with a layer (9) of magnetic metal, capable of producing a magnetic field substantially parallel to the (X) axis of the microtip.

5. A filter according to any one of claims 1 to 4, including several microtips (4) respectively provided with input electrodes (16), output electrodes (18) and nanostructures (6) which form electro-mechanical resonators having the same resonant frequency, the input electrodes being electrically connected to one another and the output electrodes also being electrically connected to one another.

6. A filter according to any one of claims 1 to 4, including several microtips (4) respectively provided with input electrodes (16), output electrodes (18) and nanostructures (6) which form electro-mechanical resonators, such microtips being distributed into a plurality of groups (G1 to Gn), the electro-mechanical resonators associated with microtips in the same group having the same resonant frequency, the input electrodes (16) being electrically connected to one another and the output electrodes (18) also being electrically connected to one another.

7. A filter according to any one of claims 1 to 6, wherein each electro-mechanical resonator is located in a space (34) where vacuum has been created.

**Patentansprüche**

1. Elektromagnetisches Filter, **dadurch gekennzeichnet, daß** es folgende Teile umfaßt:

   - Ein Substrat (2);
   - Mindestens eine Mikrospitze (4), die auf dem Substrat gebildet ist, und deren Gipfel sich durch eine Nanostruktur (6) in Form eines Balkens verlängert, der sich nach der Achse (X) der Mikrospitze erstreckt, wobei diese Mikrospitze und die Nanostruktur zumindest oberflächlich elektrisch leitfähig sind, wobei die Nanostruktur einen elektromechanischen Resonator bildet;
   - Eine elektrisch isolierende Schicht (10), die auf dem Substrat gebildet ist und eine Ausnehmung (12) umfaßt, in der sich die Mikrospitze befindet, und deutlich auf der Höhe des Gipfels dieser Mikrospitze eine Bohrung (14), die die Ausnehmung verlängert, und deren Kante diesen Gipfel umgibt;
   - Mindestens eine Eingangselektrode (16; 24 - 26) und mindestens eine Ausgangselektrode (1-8 ; 28 - 30), die auf der isolierenden Schicht gebildet sind und deutlich zu beiden Seiten der Achse der Mikrospitze zur Kante der Bohrung führen, wobei die Eingangselektrode dazu vorgesehen ist, ein zu filterndes elektrisches Signal zu erhalten, und die Ausgangselektrode dazu vorgesehen ist, ein gefiltertes elektrisches Signal zu liefern, wobei eine Koppelung zwischen diesen Elektroden und der Nanostruktur geschaffen wird, wobei diese Koppelung ermöglicht, den elektromechanischen Resonator in Resonanz zu versetzen.

2. Filter nach Anspruch 1, **dadurch gekennzeichnet, daß** die Mikrospitze (4) und die Nanostruktur (6) metallisiert sind.

3. Filter nach einem beliebigen der vorstehenden Ansprüche 1 und 2, **dadurch gekennzeichnet, daß** die Mikrospitze (4) mit zwei Ausgangselektroden (28, 30) verbunden ist, von denen eine mit der Eingangselektrode (16) elektrisch verbunden ist.

4. Filter nach einem beliebigen der vorstehenden Ansprüche 1 bis 3, **dadurch gekennzeichnet, daß** die Mikrospitze (4) und die Nanostruktur mit einer Schicht (9) eines magnetischen Metalls verkleidet sind, das geeignet ist, ein magnetisches Feld zu erzeugen, das deutlich parallel zur Achse (X) der Mikrospitze verläuft.

5. Filter nach einem beliebigen der vorstehenden Ansprüche 1 bis 4, **dadurch gekennzeichnet, daß** es mehrere Mikrospitzen (4) umfaßt, die mit Eingangselektroden (16), beziehungsweise Ausgangselektroden (18) und Nanostrukturen (6) versehen sind, die elektromechanische Resonatoren bilden, die eine gleiche Resonanzfrequenz haben, wobei die Eingangselektroden untereinander elektrisch verbunden sind und die Ausgangselektroden auch untereinander elektrisch verbunden sind.

6. Filter nach einem beliebigen der vorstehenden Ansprüche 1 bis 4, **dadurch gekennzeichnet, daß** es mehrere Mikrospitzen (4) umfaßt, die mit Eingangselektroden (16), beziehungsweise Ausgangselektroden (18) und Nanostrukturen (6) versehen sind, die elektromechanische Resonatoren bilden, wobei diese Mikrospitzen in mehrere Gruppen (G1 bis Gn) verteilt sind, wobei die den Mikrospitzen einer gleichen Gruppe zugeordneten elektromechanischen Resonatoren die gleiche Resonanzfrequenz haben, wobei die Eingangselektroden (16) untereinander elektrisch verbunden sind, und die den Mikrospitzen einer gleichen Gruppe zugeordneten Ausgangselektroden (18) untereinander elektrisch verbunden sind.

7. Filter nach einem beliebigen der vorstehenden Ansprüche 1 bis 6, **dadurch gekennzeichnet, daß** jeder elektromechanische Resonator in einem Raum (34) ist, in dem vorher Vakuum geschafft wurde.

FIG. 1

FIG. 2

FIG. 3

FIG. 4

FIG. 5

FIG. 6

FIG. 7

FIG. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **WANG et al.** Q-Enhancement of Microelectromechanical Filters via Low-Velocity Spring Coupling de K. *IEEE Ultrasonics Symposium,* 05 Octobre 1997, 323-327

- **RAKHSHANDEROO, M.R ; PANG, S. W.** *J. Vac. Sci. Technol,* 1997, vol. 15 (6), 2777
- **GÉRADIN, M ; RIXEN, D.** Théorie des vibrations. 1993